Europäisches Patentamt

European Patent Office

Office européen des brevets

(11) Veröffentlichungsnummer: **0 359 862**
**A1**

# (12) EUROPÄISCHE PATENTANMELDUNG

(21) Anmeldenummer: 88115711.9

(22) Anmeldetag: 23.09.88

(51) Int. Cl.⁵: **H05K 3/34 , B23K 26/08**

(43) Veröffentlichungstag der Anmeldung:
28.03.90 Patentblatt 90/13

(84) Benannte Vertragsstaaten:
AT BE CH DE ES FR GB GR IT LI LU NL SE

(71) Anmelder: **Siemens Aktiengesellschaft**
**Wittelsbacherplatz 2**
**D-8000 München 2(DE)**

(72) Erfinder: **Unbehauen, Ralph, Dipl.-Ing.**
**Bahnhofstrasse 72**
**D-8011 Baldham(DE)**

(54) **Verfahren zum Herstellen von elektrischen Flachbaugruppen.**

(57) Mit SMD-Bauelementen bestückte Leiterplatten (13) müssen zunächst mit Lotpastenflecken zum stumpfen Anlöten der SMD-Bauelemente versehen werden. Dies geschieht mit Hilfe von folienartigen Schablonen. Um Umrüstzeiten für unterschiedliche Leiterplattentypen zu sparen, wird für jede Leiterplatte (13) kontinuierlich eine neue Folienschablone erzeugt und auf die Leiterplatte (13) aufgelegt. Die Folie (5) wird mit Hilfe eines Laserdruckers entsprechend dem Abbild der Lotpastenflecke bedruckt. Die entsprechenden Stellen werden durch fotoschemische Verfahren aus der Folie (5) ausgewaschen.

EP 0 359 862 A1

## Verfahren zum Herstellen von elektrischen Flachbaugruppen

Die Erfindung bezieht sich auf ein Verfahren zum Herstellen von elektrischen Flachbaugruppen mit SMD-Bauelementen. Derartige Bauelemente haben keine vorstehenden Anschlußbeinchen und werden daher stumpf an die Leiterplatten angelötet. Bisher war es üblich, die Lotpastenflecke mit Hilfe von vorgefertigten Schablonen oder Siebdruckvorlagen aufzubringen, die beim Wechsel des Leiterplattentyps ausgewechselt wurden. Die Herstellung der Schablonen war mit erheblichem Kosten- und Zeitaufwand verbunden.

Der Erfindung liegt die Aufgabe zugrunde, den Aufwand für das Herstellen und Auswechseln der Schablonen zu verringern. Diese Aufgabe wird durch die Erfindung gemäß Anspruch 1 gelöst. Der Laserstrahl kann ähnlich wie bei einem Laserdrucker elektronisch gesteuert beliebige Bilder erzeugen. Dadurch ist es möglich, die Folienschablonen innerhalb der z. B. durch die Bestückung oder Prüfung vorgegebene Taktzeit einer automatisierten Fertigungsanlage herzustellen, so daß für jede Baugruppe eine eigene Schablone erzeugt werden kann. In der modernen Fertigung von elektronischen Anlagen wird zunmehmend auftragsorientiert gearbeitet. Die Baugruppen werden dann in der Reihenfolge gefertigt, wie sie in die Anlage eingesetzt werden. Das bedeutet, daß die durchschnittlichen Losgrößen erheblich kleiner werden, was einen häufigen Schablonenwechsel bedingt. Die Erfindung ermöglicht es, die Schablonen mit geringem Herstellungsaufwand rüstfrei einzusetzen. Sie trägt daher in erheblichem Maße zu angestrebten Flexibilisierung der Fertigung bei.

Vorteilhafte Weiterbildungen der Erfindung sind in den Ansprüchen 2 bis 9 gekennzeichnet:

Durch die Weiterbildung nach Anspruch 2 ist es möglich, als Druckwerkzeug einen serienmäßigen Laserdrucker zu verwenden, der allenfalls geringfügig angepaßt werden muß. Die Folie kann so bedruckt werden, daß die auszubildenden Durchbrüche von der Schutzschicht frei bleiben. Die Materialkombination kann so gewählt werden, daß die Schutzschicht dem Lösungsmittel widersteht und die Folie gelöst wird.

Durch die Weiterbildung nach Anspruch 3 müssen nur die Stellen bedruckt werden, an denen die Durchbrüche für das Aufbringen des Lotpastenmaterials angeordnet sind. Als lichthemmendes Material kann normaler Druckertoner verwendet werden.

Durch die Weiterbildung nach Anspruch 4 kann auf abdeckendes Material vollständig verzichtet werden. Der Laserstrahl wird so gesteuert, daß die auszuwaschenden Flecken nicht belichtet werden.

Die Weiterbildung nach Anspruch 5 ermöglicht die Verwendung von nichtlichtempfindlichem kostengünstigem Kunststoffmaterial für die Folie. Dabei kann der Laserstrahl relativ zur Folie so geführt werden, daß er nur die Konturen der auszuschneidenden Durchbrüche beschreibt.

Die Weiterbildung nach Anspruch 6 gibt den Aufbau einer Druckvorrichtung wieder, die sich besonders zur Durchführung des Verfahrens nach den Ansprüchen 1 bis 4 eignet. Ein besonderer Vorteil besteht darin, daß hierfür serienmäßige Teile eines Laserdruckers verwendet werden können.

Die Weiterbildung nach Anspruch 7 ermöglicht die nahezu unveränderte Verwendung eines Laserdruckers.

Die Weiterbildungen nach den Ansprüchen 8 und 9 ermöglichen ein kontinuierliches Bereitstellen von Folien für jede einzelne Leiterplatte. Die Transporteinrichtung für die Folien kann z. B. als bandartige Linearfördereinrichtung senkrecht zur Montagestraße angeordnet sein. Die mit den Durchbrüchen versehenen Schablonen werden an der Schnittstelle übergeben und unmittelbar auf die Leiterplatten aufgelegt. Dabei sichern Zentrierstifte die genaue Lage der Folie auf der Leiterplatte. In der nachfolgenden Lotpastendruckstation wird die Lotpaste auf die Leiterplatte aufgetragen und in der anschließenden Abhebestation wird die Folie von der Leiterplatte abgezogen und in einem Behälter für die gebrauchten Folien abgelegt.

Im folgenden wird die Erfindung anhand von in der Zeichnung schematisch dargestellten Ausführungsbeispielen näher erläutert:

Fig. 1 zeigt einen Lasergenerator mit einer Ablenkeinrichtung für einen Laserstrahl der aus einer Folie für eine Druckschablone Durchbrüche ausschneidet,

Fig. 2 einen Lasergenerator mit einer Ablenkeinrichtung zum direkten Belichten einer lichtaushärtenden Folie sowie mit einer Auswaschvorrichtung,

Fig. 3 eine Montagestraße für elektrische Flachbaugruppen mit einer zugeordneten Anlage zum kontinuierlichen Herstellen von Druckschablonen.

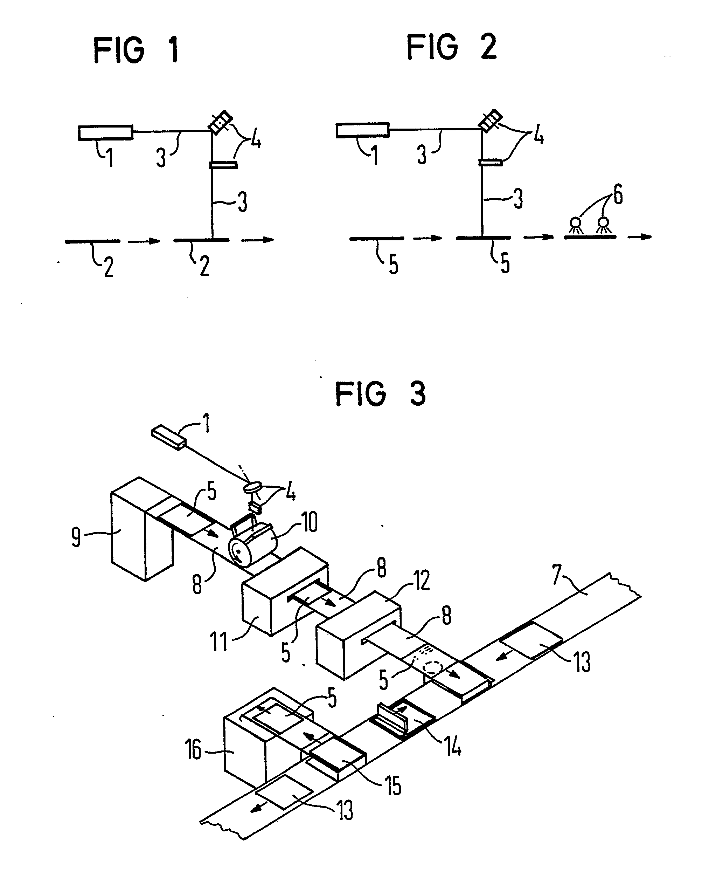

Nach Figur 1 ist ein Lasergenerator 1 über einer Transporteinrichtung für auszuschneidende Folien 2 angeordnet. Der Lasergenerator sendet einen Laserstrahl 3 aus, der mittels einer Ablenkeinrichtung 4 auf die Folie 2 gerichtet wird. Die Folie besteht aus einem lichtabsorbierenden leicht schmelzbaren und dünnen Material, daß mit hoher Geschwindigkeit vom Laserstrahl ausgeschnitten werden kann. Dabei beschreibt der Laserstrahl 3 lediglich die Konturen der auszuschneidenden Durchbrüche in der Folie 2. Diese Durchbrüche entsprechen in ihrer Konfiguration der Anordnung von auf Leiterplatten aufzutragenden Lotpastenflekken, die dem Anlöten von SMD-Bauelementen dienen. Die ausgeschnittene Folie wird als Druckschablone zum Auftragen der Lotpaste benutzt.

Nach Figur 2 kann ein Laserstrahl 3 ählich wie nach Figur 1 ablenkbar auf eine andere Folie 5 gerichtet werden. Diese besteht aus lichtaushärtendem Material. Die vom Laserstrahl beaufschlagten Flächen der Folie härten aus. Die Folien werden in einer anschließenden Auswaschvorrichtung 6 mit Lösungsmittel beaufschlagt, wodurch die nichtbelichteten Flächen ausgewaschen werden. Die so gebildeten Durchbrüche weisen die Form der aufzutragenden Lotpastenflecke auf.

Nach Figur 3 ist senkrecht zu einer Montagestraße 7 eine lineare Transporteinrichtung 8 für die Folien 5 angeordnet. Am Anfang der Transporteinrichtung 8 steht ein Folienstapel 9, aus dem die Folien 5 entnommen und auf die Transporteinrichtung 8 aufgelegt werden. Auf dieser durchläuft die Folie 5 einen Laserdrucker, der den Lasergenerator 1, die Ablenkeinrichtung 4 und eine Druckwalze 10 aufweist. Diese hatte eine elektrostatisch wirksame Beschichtung, die zur Übertragung von Tonermaterial auf die Folie 5 dient. Dieses Tonermaterial nimmt die Gestalt des von dem Laserstrahl beschriebenen Bildes an. Es kann anschließend durch Wärmestrahlung an der Folie fixiert werden. Der Transporteinrichtung 8 ist anschließend eine Belichtungsvorrichtung 11 zugeordnet, in der die nicht vom Toner beschichteten Flächen belichtet werden und dadurch aushärten. Anschließend wird die Folie 5 durch eine Auswaschvorrichtung 12 geführt, wobei die nicht ausgehärteten abgedeckten Flächen der Folie 5 zu Durchbrüchen ausgewaschen werden.

Die fertige Folie 5 stellt nun eine Schablone dar, die auf eine Leiterplatte 13 aufgelegt wird. Diese befindet sich auf der Montagestraße 7, die die Leiterplatte 13 zu einer Lotpastendruckvorrichtung 14 transportiert. Darin werden die Lotpastenflecke auf die Leiterplatte 13 aufgetragen. Anschließend gelangt die Leiterplatte 13 zu einer Folienabhebeeinrichtung 15, in der die Folie 5 von der Leiterplatte 13 abgezogen und in einen Abfallbehälter 16 überführt wird. Die fertig bedruckte Leiterplatte 13 wird danach zu einer nicht dargestellten Bestückungsstation weitertransportiert.

Bezugszeichenliste

1 Lasergenerator
2, 5 Folie
3 Laserstrahl
4 Ablenkeinrichtung
6, 12 Auswaschvorrichtung
7 Montagestraße
8 Transporteinrichtung
9 Folienstapel
10 Druckwalze
11 Belichtungsvorrichtung
13 Leiterplatte
14 Lotpastendruckvorrichtung
15 Abhebevorrichtung
16 Abfallbehälter

**Ansprüche**

1. Verfahren zum Herstellen von elektrischen Flachbaugruppen, bei denen auf eine Leiterplatte (13) je nach Bestückung mit SMD-Bauelementen Lotpastenflecke in unterschiedlicher Konfiguration mit Hilfe von entsprechend unterschiedlichen Schablonen (z. B. 5) aufgebracht werden, **dadurch gekennzeichnet,** daß die Schablone als dünne Folie (5) ausgebildet wird, daß ein elektronisch gesteuerter ablenkbarer Laserstrahl (3) mittelbar oder unmittelbar ein Abbild der Lotpastenflecke auf der Folie (2, 5) erzeugt, daß aus der Folie dementsprechende Durchbrüche ausgespart werden und daß in der laufenden Baugruppenmontage zumindest beim Wechsel des Flachbaugruppentyps jeweils eine neue Schablone hergestellt und unmittelbar eingesetzt wird.

2. Verfahren nach Anspruch 1, **dadurch gekennzeichnet,** daß die Folie (5) mit Hilfe eines Druckwerkzeuges in der Art eines Laserdruckers entsprechend der Konfiguration der Lotpastenflecke mit einer Schutzschicht bedruckt wird, die ein selektives Auswaschen der Durchbrüche ermöglicht.

3. Verahren nach Anspruch 2, **dadurch gekennzeichnet,** daß die Folie (5) aus lichtaushärtbarem Material und die Schutzschicht aus lichthemmendem Material besteht, daß die späteren Durchbrüche abgedeckt und die beschichtete Folie (5) belichtet wird und daß danach die Durchbrüche ausgewaschen werden.

4. Verfahren nach Anspruch 1, **dadurch gekennzeichnet,** daß die Folie (5) aus lichtaushärtbarem Material besteht, daß unmittelbar von dem ablenkbaren Laserstrahl (3) mit Ausnahme der späteren Durchbrüche belichtet wird, und daß danach die nicht belichteten Flächen ausgewaschen werden.

5. Verahren nach Anspruch 1, **dadurch gekennzeichnet,** daß die Folie aus lichtabsorbierenden Material von niedriger Schmelztemperatur besteht, aus dem die Durchbrüche unmittelbar durch den ablenkbaren Laserstrahl (3) ausgeschnitten werden.

6. Vorrichtung zur Durchführung des Verfahrens nach einem der Ansprüche 1 bis 4,

**dadurch gekennzeichnet,**

daß ein Lasergenerator (1) einen Laserstrahl (3) erzeugt, der über eine Ablenkeinrichtung (4) geführt ist und auf eine fotostatisch empfindliche Druckwalze (10) bzw. unmittelbar auf die Folie (5) gelenkt ist.

7. Vorrichtung nach Anspruch 6,

**dadurch gekennzeichnet,**

daß die Vorrichtung einen Laserdrucker (1, 4, 10) zum unmittelbaren Bedrucken der Folie (5) mit der lichthemmenden Schutzschicht aufweist.

8. Vorrichtung nach Anspruch 6 oder 7,

**dadurch gekennzeichnet,**

daß einer Montagestraße (7) für die Baugruppen eine Bearbeitungsanlage für die Schablonen zugeordnet ist, daß die Bearbeitungsanlage eine Transporteinrichtung (8) für die Folien (5) aufweist, daß der Transporteinrichtung (8) der Laserdrucker (1, 4, 10), eine Belichtungsvorrichtung (11) und eine Auswaschvorrichtung (12) für die Folien (5) zugeordnet sind und daß die Montagestraße (7) eine Auflegestation zum Auflegen der von der Transporteinrichtung (8) übernommenen Folien (5) auf die Leiterplatte (13), eine Lotpastendruckvorrichtung (14) und eine Folienabhebeeinrichtung (15) aufweist.

9. Vorrichtung nach Anspruch 8,

**dadurch gekennzeichnet,**

daß am Beginn der Transporteinrichtung (8) für die Folien (5) ein Folienstapel (9) mit einer Übergabeeinrichtung für die Folien (5) vorgesehen ist.

# FIG 1

# FIG 2

# FIG 3

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | DE-A-1 912 463 (IBM)<br>* Seite 14, Absatz 2 - Seite 15, Absatz 3; Figur 8 *<br>--- | 1,8 | H 05 K 3/34<br>B 23 K 26/08 |
| A | FR-A-1 578 626 (WESTERN ELECTRIC CO., INC.)<br>* Seite 9, Zeile 34 - Seite 11, Zeile 2; Seite 7, Zeile 31 - Seite 8, Zeile 17 *<br>--- | 1 | |
| A | DE-A-1 900 591 (MOTOROLA INC.)<br>* Seite 5, Absatz 1 *<br>--- | 1 | |
| A | IBM TECHNICAL DISCLOSURE BULLETIN, Band 29, Nr. 7, Seiten 2949-2950, New York, US; "Infrared laser pattern generation of solder masks"<br>* Seiten 2949-2950 *<br>--- | 1,4 | |
| A | ELECTRONICS, Band 42, Nr. 2, 20. Januar 1969, Seiten 81-85; T.M. JACKSON et al.: "Laser cuts masks to size, eliminating most errors"<br>----- | | |

RECHERCHIERTE
SACHGEBIETE (Int. Cl.4)

H 05 K
B 23 K

Der vorliegende Recherchenbericht wurde für alle Patentansprüche erstellt

| Recherchenort | Abschlußdatum der Recherche | Prüfer |
|---|---|---|
| DEN HAAG | 27-04-1989 | SCHUERMANS N.F.G. |

EPO FORM 1503 03.82 (P0403)